Europäisches Patentamt

European Patent Office

Office européen des brevets

(11) Veröffentlichungsnummer: **0 253 441**
**A2**

(12) **EUROPÄISCHE PATENTANMELDUNG**

(21) Anmeldenummer: 87201299.2

(22) Anmeldetag: 08.07.87

(51) Int. Cl.⁴: **H03H 17/02** , H04B 9/00

(30) Priorität: 11.07.86 DE 3623301

(43) Veröffentlichungstag der Anmeldung:
**20.01.88 Patentblatt 88/03**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB IT**

(72) Erfinder: **Schwartz, Wolfgang**
**Auf der Koppel 3**
**D-2000 Hamburg 65(DE)**
Erfinder: **Warmuth, Leo**
**Osterstrasse 156**
**D-2000 Hamburg 19(DE)**
Erfinder: **Grzyb, Claus**
**Holsteiner Chaussee 346e**
**D-2000 Hamburg 61(DE)**

(74) Vertreter: **Poddig, Dieter, Dipl.-Ing. et al**
**Philips Patentverwaltung GmbH**
**Wendenstrasse 35 Postfach 10 51 49**
**D-2000 Hamburg 1(DE)**

(54) **Digitalschaltung.**

(57) Die Erfindung betrifft eine Digitalschaltung, der ein serielles Eingangssignal zugeführt wird und die schnelle Signalschwankungen unterdrückt. Die Digitalschaltung enthält eine Integratorschaltung (I), die durch Integration des seriellen Eingangssignals ein Mehr-Bit-Signal erzeugt. Das Ausgangssignal der Integratorschaltung (I) wird einer Auswerteschaltung (2) zugeführt, die ein serielles Ausgangssignal erzeugt, das einen ersten Signalzustand annimmt, wenn das Mehr-Bit-Signal größer als ein erster Schwellwert ist, und einen zweiten Signalzustand, wenn das Mehr-Bit-Signal kleiner als ein zweiter Schwellwert ist.

Fig.1

## Digitalschaltung

Die Erfindung betrifft eine Digitalschaltung, der ein serielles Eingangssignal zugeführt wird und die schnelle Signalschwankungen unterdrückt.

Geräte der Unterhaltungselektronik, wie z.B. Fernsehempfänger, werden häufg mittels einer Fernbedienungsanlage gesteuert. Solche Fernbedienungsanlagen enthalten enen Sender, dessen Sendesignale von einem Empfänger empfangen werden und die zu einem Mikroprozessor weitergegeben werden, der die vom Bediener gewünschte Einstellung vornimmt.

Bei Fernsehempfängern wird zur Übertragung solcher Signale häufg Infrarotlicht verwendet. Der Infrarotlichtempfänger erhält vom Infrarotlichtsender serielle Signale, die über einen regelbaren Verstärker dem Mikroprozessor zugeführt werden. Bei längeren Sendepausen, d.h. wenn vom Infrarotlichtsender kein Sendesignal abgegeben wird, wird der Verstärker so geregelt, daß die maximale Verstärkung vorliegt. Dadurch kann vom Infrarotlichtempfänger empfangenes Störlicht über den Verstärker zum Mikroprozessor gelangen.

Das serielle Signal weist zwei Sgnalzustände auf, die in der Regel mit "l" und "0" oder "High" und "Low" bezeichnet werden. Das Störlicht ruft in dem seriellen Signal schnelle Signalschwankungen hervor, d.h. das serielle Signal ist nur kurzzeitig in einem Signalzustand, z.B. im Zustand "l". Die Frequenz, mit der sich die Signalzustände im seriellen Signal ändern, ist bei enem Störlicht sehr viel größer als bei einem Sendesignal.

Der Mikroprozessor wertet das Sendesignal aus. Durch Erscheinen einer solchen Störung wird der sonstige Programmablauf kurzzeitig unterbrochen. Treten diese Unterbrechungen durch die höherfrequenten Störungen häufiger auf, wird das sonstige Programm des Mikroprozessors behindert.

Der Erfindung liegt die Aufgabe zugrunde, eine Digitalschaltung der eingangs genannten Art so auszubilden, daß die Störungen im seriellen Ausgangssignal der Digitalschaltung weitgehend unterdrückt werden.

Diese Aufgabe wird erfindungsgemäß dadurch gelöst, daß eine Integratorschaltung durch Integration des seriellen Eingangssignals ein Mehr-Bit-Signal erzeugt und daß in einer Auswerteschaltung aus dem Mehr-Bit-Signal ein serielles Ausgangssignal erzeugt wird, das einen ersten Signalzustand annimmt, wenn das Mehr-Bit-Signal größer als ein erster Schwellwert ist, und einen zweiten Signalzustand, wenn das Mehr-Bit-Signal kleiner als ein zweiter Schwellwert ist.

Bei der erfindungsgemäßen Digitalschaltung wird durch Integration des seriellen Eingangssignals erreicht, daß das Ausgangssignal der Integratorschaltung einen dreieckförmigen Verlauf hat. Nur wenn das Ausgangssignal der Integratorschaltung einen bestimmten Schwellwert über-bzw. unterschreitet, detektiert die Auswerteschaltung, daß ein Signalwechsel m seriellen Eingangssignal vorhanden ist, also keine Störung vorliegt. Eine solche Integratorschaltung besteht im einfachsten Fall aus einem Addierer, der das Eingangssignal und das in einem Register verzögerte Integratorausgangssignal addiert. Die Integratorschaltung muß so ausgelegt werden, daß nur dann ein bestimmter Wert, der Schwellwert, erreicht wird, wenn ein Signalzustand eine bestimmte Dauer überschreitet. Es soll also ein Signalwechsel erkannt werden, wenn die Frequenz, mit der sich die Zustände des Signals ändern, niedriger ist als die Frequenz, wenn Störungen auftreten.

Die Digitalschaltung weist ein Tiefpaßverhalten in bezug auf die seriellen Eingangssignale auf, denn es kommt nur bei niedrigen Frequenzen ein Zustandswechsel vor.

Eine Ausführungsform für die Integratorschaltung enthält einen ersten Schaltungsteil, in dem die Ausgangssignale zweier in Reihe geschalteter, eine Verzögerungsdauer von einem Takt aufweisender Verzögerungsglieder, deren erstem Verzögerungsglied das serielle Eingangssignal zugeführt wird, ein Zwei-Bit-Ausgangssignal bilden, und einen zweiten Schaltungsteil mit einem ersten Addierer, dessen erstem Eingang das Zwei-Bit-Ausgangssignal und dessen zweitem Eingang das Ausgangssignal eines zweiten Addierers zugeführt wird und mit einer Teilerschaltung mit einem Teilverhältnis von 32, der das das Ausgangssignal der Integratorschaltung bildende Mehr-Bit-Ausgangssignal eines Verzögerungsgliedes zugeführt wird, das nach jedem zweiten Takt das Ausgangssignal des ersten Addierers speichert, und um zwei Takte verzögert, und deren Ausgangssignal in dem zweiten Addierer vom Mehr-Bit-Ausgangssignal subtrahiert wird.

Die beiden Verzögerungsglieder des ersten Schaltungsteils können z.B. D-Kippglieder sein. Wenn das Ausgangssignal des ersten D-Kippgliedes das höherwertige Bit bildet, kann der erste Schaltungsteil auch mit einem Addierer realisiert werden, dessen erstem Eingang das serielle Eingangssignal und dessen zweitem Eingang das Ausgangssignal eines Teilers mit einem Teilverhältnis von 2 zugeführt wird. Dem Teiler wird dabei das um einen Takt verzögerte serielle Eingangssignal zugeführt. Der zweite Schaltungsteil enthält die schon oben beschriebene einfache Integratorstruktur und einen weiteren Zweig mit einem Teiler mit einem Teilerverhältnis von 32. Die Integratorschaltung erzeugt ein 7-Bit-Signal, das den maximalen dezimalen Wert 96 und den minimalen dezimalen Wert 31 erreichen kann, wenn das 7-Bit-Signal als Dualzahl aufgefaßt wrd. Die Schwellwerte in der Auswerteschaltung müssen also so gelegt werden, daß sie innerhalb der Werte 96 und 31 liegen.

Eine Ausführungsform für die Auswerteschaltung enthält eine Logikschaltung, die die drei höchstwertigen Bits des Mehr-Bit-Signals verknüpft und die ein das serielle Ausgangssignal erzeugendes Kippglied setzt, wenn das Mehr-Bit-Signal größer als der erste Schwellwert ist, und das Kippglied zurücksetzt, wenn das Mehr-Bit-Signal kleiner als der zweite Schwellwert ist.

Die Logikschaltung enthält ein NOR-Gatter, dessen einem Eingang das höchstwertige Bit zugeleitet wird, dessen anderer Eingang mit dem Ausgang eines ersten UND-Gatters, das die anderen Bits erhält, und dessen Ausgang mit dem Rücksetz-Eingang des Kippgliedes verbunden ist, und ein zweites UND-Gatter, dessen einem Eingang das höchstwertige Bit zugeführt wird, dessen anderer Eingang mit dem Ausgang eines ODER-Gatters, das die anderen Bits erhält, und dessen Ausgang mit dem Setz-Eingang des Kippgliedes verbunden ist.

Die Logikschaltung ist so realisiert, daß der erste Schwellwert dem Wert 80 und der zweite Schwellwert dem Wert 48 entspricht.

Wie eingangs erwähnt, kann die Digitalschaltung in einer Infrarotempfangseinrichtung verwendet werden. Das in ein elektrisches Signal von einer Empfangsschaltung umgesetzte Infrarotlichtsignal wird dabei über einen regelbaren Verstärker zur Digitalschaltung geleitet, deren Ausgangssignal z.B. einem Mikroprozessor zugeführt wird.

Anhand der Zeichnungen wird im folgenden ein Ausführungsbeispiel der Erfindung näher erläutert. Es zeigen:

Fig. 1 die erfindungsgemäße Digitalschaltung und

Fig. 2 ein detailliertes Ausführungsbeispiel der Auswerteschaltung.

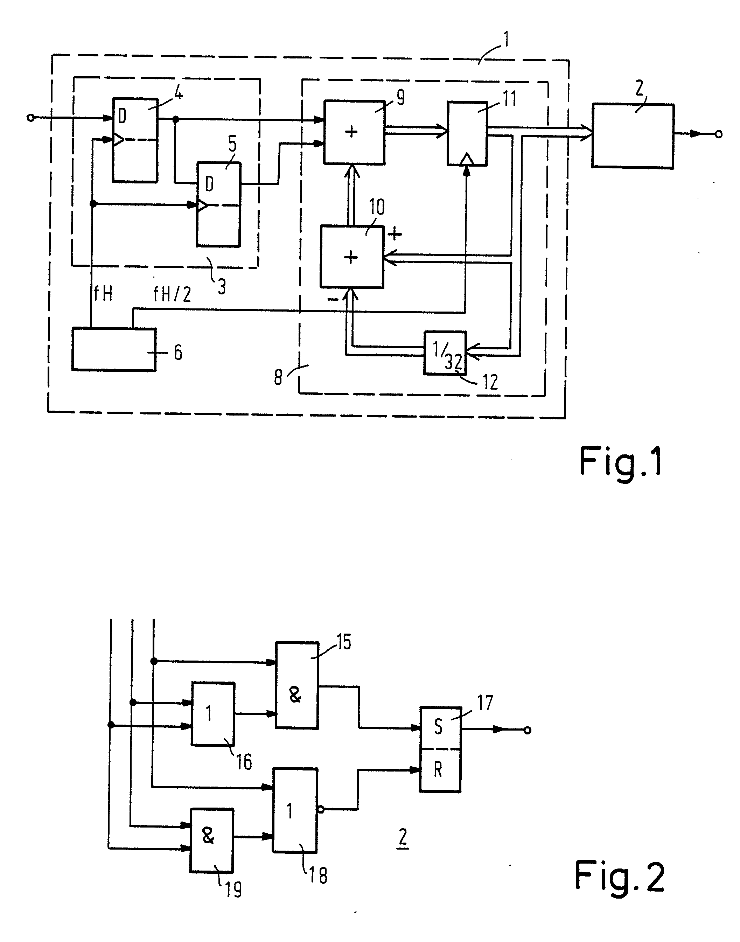

In Fig. 1 wird das serielle Eingangssignal einer Integratorschaltung 1 zugeführt, die ein 7-Bit-Ausgangssignal erzeugt, welches einer Auswerteschaltung 2 zugeführt wird, die ein serielles Ausgangssignal abgibt. Das serielle Eingangssignal weist zwei Signalzustände auf, die im folgenden mit "1" und "0" bezeichnet werden. In der aus der Integratorschaltung 1 und der Auswerteschaltung 2 bestehenden Digitalschaltung wird ein serielles Ausgangssignal erzeugt, welches keinen Signalzustand enthält, der von kurzer Dauer ist. Signalzustände von kurzer Dauer, d.h. Signale mit schnellen Signalschwankungen, werden von der Digitalschaltung unterdrückt und sind im seriellen Ausgangssignal nicht mehr vorhanden. Bei Störungen ist die Frequenz, mit der sich die Zustände des Signales ändern, höher als bei einem ungestörten Signal.

Die Integratorschaltung 1 enthält einen ersten Schaltungsteil 3 mit zwei D-Kippgliedern 4 und 5. Dem D-Eingang des D-Kippgliedes 4 wird das serielle Eingangssignal und dessen Takteingang ein Taktsignal mit einer Taktfrequenz fH von einem Taktsignalgenerator 6 zugeführt. Mit jeder wirksamen Flanke des Taktsignals wird der im seriellen Eingangssignal vorliegende Signalzustand gespeichert, d.h. eine "1" oder "0", und am Ausgang des D-Kippgliedes 4 zur Verfügung gestellt. Das serielle Ausgangssignal des D-Kippgliedes 4 wird dem D-Eingang des D-Kippgliedes 5 zugeleitet. Dieses D-Kippglied 5 erhält ebenfalls das Taktsignal (Frequenz fH) vom Taktsignalgenerator 6. Das Ausgangssignal des D-Kippgliedes 4 und des D-Kippgliedes 5 bilden das Zwei-Bit-Eingangssignal eines zweiten Schaltungsteils 8 der Integratorschaltung 1. Das höherwertige Bit bildet dabei das Ausgangssignal des D-Kippgliedes 4.

Das Zwei-Bit-Eingangssignal des zweiten Schaltungsteiles 8 wird einem Addierer 9 zugeführt, dessen anderem Eingang ein 7-Bit-Signal von einem weiteren Addierer 10 zugeführt wird. Das 7-Bit-Ausgangssignal des Addierers 9 wird einem Register 11 zugeleitet, welches von dem Taktsignalgenerator 6 ein weiteres Taktsignal erhält, dessen Frequenz fH/2 gleich der Hälfte der Frequenz des Taktsignales ist, das den beiden D-Kippgliedern 4 und 5 zugeleitet wird. Das Register 11 speichert also nur während jedes zweiten Taktes das Ausgangssignal des Addierers 9 und verzögert außerdem dieses Signal um zwei Takte. Das Ausgangssignal des Registers 11 bildet das Ausgangssignal der Integratorschaltung 1. Außerdem wird es dem ersten Eingang des Addierers 10 und einer Teilerschaltung 12 zugeführt, die ein Teilerverhältnis von 32 aufweist. Das Ausgangssignal der Teilerschaltung 12 wird dem zweiten Eingang des Addierers 10 zugeführt. Eine solche Teilerschaltung wird praktisch realisiert, indem man eine Stellenverschiebung um fünf Stellen durchführt. Mit Hilfe des Addierers 10 wird das Ausgangssignal der Teilerschaltung 12 vom Mehr-Bit-Ausgangssignal des Registers 11 subtrahiert. Dabei wird im Addierer 10 das Zweierkomplement des Ausgangssignals der Teilerschaltung gebildet und dann eine Addition mit dem Mehr-Bit-Ausgangssignal durchgeführt.

Wird das Mehr-Bit-Ausgangssignal als Dualzahl interpretiert, so beträgt der maximale Wert des Mehr-Bit-Ausgangssignals dezimal 96 und der minimale Wert des Ausgangssignals dezimal 31. Je

länger ein Signalzustand im seriellen Eingangssignal dauert, um so mehr nähert sich das Ausgangssignal der Integratorschaltung I dem Wert 96 bzw. 31 an. Das Ausgangssignal hat also einen dreieckförmigen Verlauf. Bei schnellen Signalschwankungen im seriellen Eingangssignal ist der Wert des Ausgangssignals der Integratorschaltung I weit von den Grenzwerten entfernt.

In der Auswerteschaltung 2 wird nun festgestellt, ob ein Zustandswechsel im seriellen Eingangssignal durch eine Störung hervorgerufen wurde oder ein ungestörtes Signal vorhanden ist. Ein Ausführungsbeispiel für die Auswerteschaltung 2 ist in Fig. 2 dargestellt. Der Auswerteschaltung 2 werden die drei höchstwertigen Bits des 7-Bit-Ausgangssignals der Integratorschaltung I zugeführt. Das höchstwertige Bit wird dabei einem ersten Eingang eines UND-Gatters I5 zugeführt, dessen anderem Eingang die in einem ODER-Gatter I6 verknüpften anderen Bits zugeführt werden. Der Ausgang des UND-Gatters I5 ist mit einem Setz-Eingang eines Kippgliedes I7 verbunden. Das Ausgangssignal des Kippgliedes I7 bildet das serielle Ausgangssignal der Auswerteschaltung 2. Der Rücksetz-Eingang des Kippgliedes I7 ist mit dem Ausgang eines NOR-Gatters I8 verbunden, dessen einem Eingang das höchstwertige Bit und dessen anderem Eingang das Ausgangssignal eines ODER-Gatters I9 zugeführt wird, das die beiden anderen Bits verknüpft.

Die aus den Gattern I5, I6, I8 und I9 gebildete Logikschaltung der Auswerteschaltung 2 stellt fest, ob das Ausgangssignal der Integratorschaltung I den Wert 80 überschritten hat, um dann das Kippglied I7 zu setzen und ob das Ausgangssignal den Wert 48 unterschritten hat, um das Kippglied I7 zurückzusetzen. Der erste Schwellwert der Auswerteschaltung ist also 80 und der zweite ist 48. Es hat sich nämlich in praktischen Versuchen gezeigt, daß bei diesen Schwellwerten eine sichere Störunterdrückung erreicht wird.

Eine solche Digitalschaltung kann zur Störunterdrückung in einer Infrarotlichtempfangseinrichtung verwendet werden. Das empfangene Infrarotlicht wird in einer Empfangsschaltung in ein elektrisches Signal umgesetzt und einem regelbaren Verstärker zugeführt. Das Ausgangssignal des regelbaren Verstärkers wird nun der Digitalschaltung zugeführt, die eine Störunterdrückung durchführt und dessen serielles Ausgangssignal z.B. einem Mikroprozessor zugeführt wird. Wenn der Mikroprozessor z.B. mit einer Taktfrequenz von 2 MHz arbeitet, die ebenfalls die Taktfrequenz des Taktsignales ist, das den D-Kippgliedern zugeführt wird, unterdrückt die Digitalschaltung alle Signalschwankungen, die oberhalb von 20 KHz liegen.

## Ansprüche

I. Digitalschaltung, der ein serielles Eingangssignal zugeführt wird und die schnelle Signalschwankungen unterdrückt, dadurch gekennzeichnet, daß eine Integratorschaltung (I) durch Integration des seriellen Eingangssignals ein Mehr-Bit-Signal erzeugt und daß in einer Auswerteschaltung (2) aus dem Mehr-Bit-Signal ein serielles Ausgangssignal erzeugt wird, das einen ersten Signalzustand annimmt, wenn das Mehr-Bit-Signal größer als ein erster Schwellwert ist, und einen zweiten Signalzustand, wenn das Mehr-Bit-Signal kleiner als ein zweiter Schwellwert ist.

2. Digitalschaltung nach Anspruch I, dadurch gekennzeichnet, daß die Integratorschaltung (I) einen ersten Schaltungsteil (3) enthält, in dem die Ausgangssignale zweier in Reihe geschalteter, eine Verzögerungsdauer von einem Takt aufweisender Verzögerungsglieder (4, 5), deren erstem Verzögerungsglied (4) das serielle Eingangssignal zugeführt wird, ein Zwei-Bit-Ausgangssignal bilden, und einen zweiten Schaltungsteil (8) mit einem ersten Addierer (9), dessen erstem Eingang das Zwei-Bit-Ausgangssignal und dessen zweitem Eingang das Ausgangssignal eines zweiten Addierers (I0) zugeführt wird, und mit einer Teilerschaltung (I2) mit einem Teilerverhältnis von 32, der das das Ausgangssignal der Integratorschaltung (I) bildende Mehr-Bit-Ausgangssignal eines Verzögerungsgliedes (II) zugeführt wird, das nach jedem zweiten Takt das Ausgangssignal des ersten Addierers (9) speichert und um zwei Takte verzögert, und deren Ausgangssignal in dem zweiten Addierer (I0) vom Mehr-Bit-Ausgangssignal subtrahiert wird.

3. Digitalschaltung nach einem der vorhergehenden Ansprüche, dadurch gekennzeichnet, daß in der Auswerteschaltung (2) eine Logikschaltung (I5 bis I9) die drei höchstwertigen Bits des Mehr-Bit-Signals verknüpft und ein das serielle Ausgangssignal erzeugendes Kippglied (I7) setzt, wenn das Mehr-Bit-Signal größer als der erste Schwellwert ist, und das Kippglied zurücksetzt, wenn das Mehr-Bit-Signal kleiner als der zweite Schwellwert ist.

4. Digitalschaltung nach Anspruch 3, dadurch gekennzeichnet, daß die Logikschaltung ein NOR-Gatter (I8) enthält, dessen einem Eingang das höchstwertige Bit zugeleitet wird, dessen anderer Eingang mit dem Ausgang eines ersten UND-Gatters (I9), das die anderen Bits erhält, und dessen Ausgang mit dem Rücksetz-Eingang des Kippgliedes (I7) verbunden ist, und ein zweites UND-Gatter (I5), dessen einem Eingang das höchstwertige Bit zugeführt wird, dessen anderer Eingang mit dem Ausgang eines ODER-Gatters (l6), das die anderen Bits erhält, und dessen Ausgang mit dem Setz-Eingang des Kippgliedes (l7) verbunden ist.

5. Verwendung einer Digitalschaltung nach einem der vorhergehenden Ansprüche in einer Infrarotempfangseinrichtung.

Fig.1

Fig.2

PHD 86-092